(19) Europäisches Patentamt
European Patent Office
Office européen des brevets

(11) **EP 1 935 041 B1**

(12) **FASCICULE DE BREVET EUROPEEN**

(45) Date de publication et mention de la délivrance du brevet:
**25.05.2011 Bulletin 2011/21**

(21) Numéro de dépôt: **06820161.5**

(22) Date de dépôt: **06.10.2006**

(51) Int Cl.:
*G01R 33/02* [(2006.01)]   *G01R 33/06* [(2006.01)]
*H01F 1/153* [(2006.01)]   *H01L 43/10* [(2006.01)]
*H01L 43/12* [(2006.01)]

(86) Numéro de dépôt international:
**PCT/FR2006/002253**

(87) Numéro de publication internationale:
**WO 2007/042649 (19.04.2007 Gazette 2007/16)**

(54) **PROCEDE DE FABRICATION D'UN CAPTEUR A MAGNETO-IMPEDANCE**

VERFAHREN ZUM HERSTELLEN EINES MAGNETOIMPEDANZ-SENSORS

METHOD FOR MAKING A MAGNETO-IMPEDANCE SENSOR

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **13.10.2005 FR 0510456**

(43) Date de publication de la demande:
**25.06.2008 Bulletin 2008/26**

(73) Titulaire: **CENTRE NATIONAL DE LA RECHERCHE SCIENTIFIQUE (CNRS)
75794 Paris Cedex 16 (FR)**

(72) Inventeurs:
• **ALVES, Francisco
F-94500 Champigny sur Marne (FR)**
• **BENSALAH, Abed-Djebar
F-94235 Cachan Cedex (FR)**

(74) Mandataire: **Cabinet Plasseraud
52, rue de la Victoire
75440 Paris Cedex 09 (FR)**

(56) Documents cités:
**EP-A- 0 271 657     EP-A1- 0 299 498
US-A- 5 252 148     US-A- 5 852 531
US-A- 6 053 989**

• **ALVES^1 F: "Flash stress annealings in nanocrystalline alloys for new inductive components" JOURNAL OF MAGNETISM AND MAGNETIC MATERIALS, ELSEVIER, AMSTERDAM, NL, vol. 226-230, mai 2001 (2001-05), pages 1490-1492, XP004319232 ISSN: 0304-8853**
• **ALVES F ET AL: "Stress-induced anisotropy in Finemet- and Nanoperm-type nanocrystalline alloys using flash annealing" JOURNAL OF MAGNETISM AND MAGNETIC MATERIALS, ELSEVIER SCIENCE PUBLISHERS, AMSTERDAM, NL, vol. 215-216, juin 2000 (2000-06), pages 387-390, XP004201390 ISSN: 0304-8853**
• **ALVES F ET AL: "Influence of rapid stress annealing on magnetic and structural properties of nanocrystalline Fe74.5Cu1Nb3Si15.5B6 alloy" JOURNAL OF MAGNETISM AND MAGNETIC MATERIALS, ELSEVIER SCIENCE PUBLISHERS, AMSTERDAM, NL, vol. 294, no. 2, juillet 2005 (2005-07), pages e141-e144, XP004929293 ISSN: 0304-8853**
• **YOSHIZAWA Y ET AL: "New Fe-based soft magnetic alloys composed of ultrafine grain structure" JOURNAL OF APPLIED PHYSICS USA, vol. 64, no. 10, 15 novembre 1988 (1988-11-15), pages 6044-6046, XP002418294 ISSN: 0021-8979**

**Description**

La présente invention est relative aux procédés de fabrication de capteur à magnéto-impédance.

Plus particulièrement, l'invention concerne un procédé de fabrication d'un capteur à magnéto-impédance nanocristallin comprenant un élément en matériau magnétique de la famille FINEMET (Fe, Si, B, Cu, Nb).

Par famille FINEMET, on comprend un matériau à base des composants Fer, Silicium, Bore, Cuivre, Niobium. La composition est en général voisine de $Fe_{75}Cu_1Nb_3Si_{15}B_6$, cependant, certaines proportions peuvent varier légèrement.

Des procédés connus de fabrication de capteurs à magnéto impédance utilisant des composés FINEMET présente une étape de recuit du matériau magnétique qui permet de passer d'un liquide amorphe à une structure nanocristalline. Cette étape de recuit se passe traditionnellement à une température supérieure à 600˚C dans un four, et sous une contrainte, par exemple une contrainte mécanique importante notamment de 100MPa. De cette manière, on forme un matériau magnétique dont la perméabilité magnétique relative est relativement faible, c'est-à-dire de l'ordre de 500.

Cependant, la variation relative de l'impédance ($\Delta Z/Z$) de ce capteur soumis à un champ magnétique est en général faible et inférieure à 50%. De plus, la sensibilité de tels capteurs est en général faible et de l'ordre de 0,2%/A/m. Enfin, ce type de capteurs n'est linéaire que sur certaines plages réduites, et il est nécessaire de se placer préalablement au point de fonctionnement présentant une plage linéaire, par exemple en utilisant un courant de magnétisation important. Enfin, l'étape de recuit est relativement longue et le matériau ayant subi une telle étape de recuit est fragilisé.

Des procédés et des capteurs connus sont décrits par US 5 852 531; EP 0 271 657 A2; EP 0 299 498 A1; US 5 252 148; F. Alves, "Flash stess annealings in nanocrystalline alloys for new inductive components", Journal of Magnetism and Magnetic Materials, vol. 226-230, p. 1490-1492, (2001); F. Alves et al., "Stress-induced anisotropy in Finemet- and Nanoperm-type nanocrystalline alloy using flash annealing", Journal of Magnetism and Magnetic Materials, vol. 215-216, p. 387-390, (2000); F. Alves et al., "Influence of rapid stress annealing on magnetic and structural properties of nanocrystalline Fe74.5Cu1Nb3Si15.5B6 alloy", Journal of Magnetism and Magnetic Materials, vol. 294, p. e141-e144, (2005); Y. Yoshizawa et al., "New Fe-based soft magnetic alloys composed of ultrafine grain structure", Journal of Applied Physics, vol. 64, p. 6044-6046, (1988); US 6 053 989.

La présente invention a notamment pour but de pallier ces inconvénients.

A cet effet, l'invention propose un procédé de fabrication du genre en question comprenant une étape de recuit de l'élément en matériau magnétique effectuée à une température comprise entre 600˚C et 700˚C pendant 5 à 20 secondes, l'élément de matériau magnétique étant soumis à une perturbation extérieure de faible intensité afin de provoquer la formation de domaines magnétiques transverses, ledit matériau magnétique ayant, après recuit, une perméabilité magnétique relative supérieure à 10 000, et suivant lequel on forme le capteur magnétique par l'interposition d'une couche conductrice entre une première couche de matériau magnétique et une seconde couche de matériau magnétique, le rapport de l'épaisseur de la couche conductrice sur l'épaisseur de l'une des couches de matériau magnétique est compris entre 0,5 et 5.

Grâce à ces dispositions, un capteur obtenu à partir de ce type de procédé de fabrication présente une sensibilité fortement améliorée, et qui peut avoisiner les 1,3%/A/m. Ceci permet donc de fabriquer des capteurs magnétiques de grande sensibilité, par exemple pour des applications dans le domaine du contrôle non destructif. Le matériau ainsi recuit pourrait également servir dans la réalisation de concentrateurs magnétiques dans les capteurs « search-coil » pour l'observation du champ magnétique propre des planètes.

De plus, le demandeur a établi que l'utilisation de matériaux magnétiques doux, c'est-à-dire avec une perméabilité magnétique élevée, permet d'obtenir une amplitude de la variation relative d'impédance ($\Delta Z/Z$) élevée et de l'ordre 700% dans certaines conditions de fonctionnement. Il est essentiel d'imposer une perturbation au matériau magnétique, afin de provoquer la formation de domaines magnétiques transverses, ce qui permet de réduire l'hystérésis du matériau. Cependant, cette perturbation doit être faible pour que la perméabilité magnétique relative soit élevée. De plus, le matériau magnétique ainsi obtenu possède des propriétés de non magnéto-striction, ce qui rend donc le matériau peu sensible aux contraintes externes.

Dans divers modes de réalisation du procédé selon l'invention, on peut éventuellement avoir recours en outre à l'une et/ou à l'autre des dispositions suivantes :

- la perturbation comprend une contrainte mécanique en élongation d'une intensité comprise entre 1 et 5 MPa ;
- la perturbation comprend la soumission à un champ magnétique transverse ;
- on réalise le capteur magnétique sous la forme d'un ruban de matériau magnétique d'une longueur sensiblement égale à 10 fois la largeur et d'épaisseur inférieure à 50$\mu$m ;
- la longueur du capteur magnétique est comprise entre 1 millimètre et 1 centimètre ;
- la couche conductrice est réalisée à partir de l'un des métaux suivants : or, cuivre, aluminium, laiton ;
- on interpose une couche isolante d'oxyde entre la couche conductrice et les couches de matériaux magnétiques ;

- l'épaisseur des couches de matériau magnétique est comprise entre 1$\mu$m et 50$\mu$m.
- l'épaisseur de la couche conductrice est comprise entre 10$\mu$m et 100$\mu$m ;
- le rapport de la largeur de la couche conductrice sur la largeur de l'une des couches en matériau magnétique est compris entre 0,1 et 1.

D'autres caractéristiques et avantages de l'invention apparaîtront au cours de la description suivante d'un de ses modes de réalisation, donné à titre d'exemple non limitatif, en regard des dessins joints.

Sur les dessins :

- la figure 1 est une vue schématique en perspective d'un capteur selon un premier mode de réalisation conforme à l'invention ;
- la figure 2A est une vue schématique en perspective d'un capteur selon un deuxième mode de réalisation conforme à l'invention ;
- la figure 2B est une vue en coupe du capteur de la figure 2A ;
- la figure 3 est une vue en perspective d'un capteur selon un troisième mode de réalisation conforme à l'invention ;
- les figures 4A et 4B sont des schémas électriques représentant la mise en oeuvre pratique d'un capteur conforme à l'invention.

Sur les différentes figures, les mêmes références désignent des éléments identiques ou similaires.

Selon l'invention, on réalise un capteur à magnéto-impédance à partir d'une base amorphe d'un matériau de la famille FINEMET. Les matériaux de cette famille possèdent des propriétés physiques légèrement différentes en fonction de leur composition. En règle générale, ces matériaux sont constitués à environ 75% de Fer. Le Silicium permet de faire varier la résistivité du capteur. Le niobium, présent à environ 3%, permet de freiner la formation de cristaux lors de l'étape de recuit. Le matériau magnétique comprend de plus approximativement 1% de Cuivre.

Cette composition peut varier légèrement en fonction de l'application, ou en fonction des spécifications mécaniques.

Au cours du procédé de fabrication conforme à l'invention, on soumet cette base amorphe de FINEMET à une étape de recuit. Cette étape consiste à former la structure nanocristalline dans le matériau magnétique. Pour cela, on peut placer le matériau à une température comprise entre 600 et 700˚C, de préférence 660˚C. En effet, le demandeur a montré par expérience que cette température permet au matériau magnétique d'avoir une variation d'impédance magnétique maximale $\Delta Z/Z$, comme le montre le tableau suivant établi à partir de tests sur un capteur :

**Tableau 1 Effet de la température de recuit (sans contrainte mécanique)**

| T (˚C) | $\left(\dfrac{\Delta Z}{Z_{sat}}\right)_{Max}$ (%) | fréquence |
|--------|------------|-----------|
| 500 | 150 | |
| 600 | 592 | |
| 660 | 597 | 50 kHz |
| 700 | 474 | |
| 750 | 9.7 | |
| 800 | 9.6 | |

A titre de comparaison, des capteurs à magnétorésistance géante présentent une variation relative de l'ordre de quelques dizaines de pourcent, et une sensibilité maximale de 0,01%/A/m. Par ailleurs, la variation relative maximale des capteurs à magnéto-impédance géante conventionnels, par exemple des capteurs à magnéto-impédance utilisant un alliage de CoFeSiB est atteinte à une fréquence de l'ordre de plusieurs dizaines de MHz, et n'excède en général pas 100%. La sensibilité de tels capteurs est en général inférieure à 0,2%/A/m. La fréquence relativement faible pour laquelle l'amplitude maximale de variation d'impédance est atteinte permet l'utilisation d'une électronique de détection à basse fréquence donc moins complexe et moins coûteuse.

Le matériau est placé à cette température pendant une courte période, de l'ordre de quelques secondes. La structure nanocristalline se forme alors. Cependant, afin de supprimer tout phénomène d'hystérésis, on forme dans le matériau des domaines magnétiques transverses, en imposant une perturbation au matériau magnétique. Conformément à l'invention, cette perturbation doit être de faible intensité. De cette manière, les domaines transverses sont de grande dimension. Ainsi, pour un capteur magnétique d'une largeur de 1cm, les domaines peuvent être de l'ordre de 500$\mu$m. Ainsi, la perméabilité relative du matériau, $\mu$, est supérieure à 10000 et la rémanence est proche de zéro, inférieure à 0.02T, qui assure une linéarité de la courbe d'aimantation sans hystérésis.

De plus, grâce à cette étape de recuit, on atteint un coefficient de magnétostriction inférieure à 0,3ppm (donc peu sensible aux contraintes externes de conditionnement du capteur) et la rapidité du recuit permet de moins fragiliser le matériau et d'avoir en conséquence un matériau plus ductile lors de la fabrication du capteur.

La perturbation de faible intensité peut être simplement une contrainte mécanique en fraction. Cette contrainte doit être faible, de l'ordre de 1 à 5 MPa. Ce type de perturbation est simple à mettre en oeuvre, par exemple, à partir de rouleaux de traction qui imposent ladite contrainte mécanique au cours de l'étape de recuit. De plus, une forte industrialisation d'un tel procédé est possible.

Cependant, selon une variante de réalisation, cette perturbation peut être un champ magnétique. Ce type de perturbation peut permettre de former des capteurs plans, par exemple formés par dépôt sur des substrats, qui ne pourraient être soumis à une contrainte mécanique de type traction. Ainsi, en soumettant le matériau FINEMET déposé sur un substrat, on peut former des domaines transverses à l'intérieur de ce matériau.

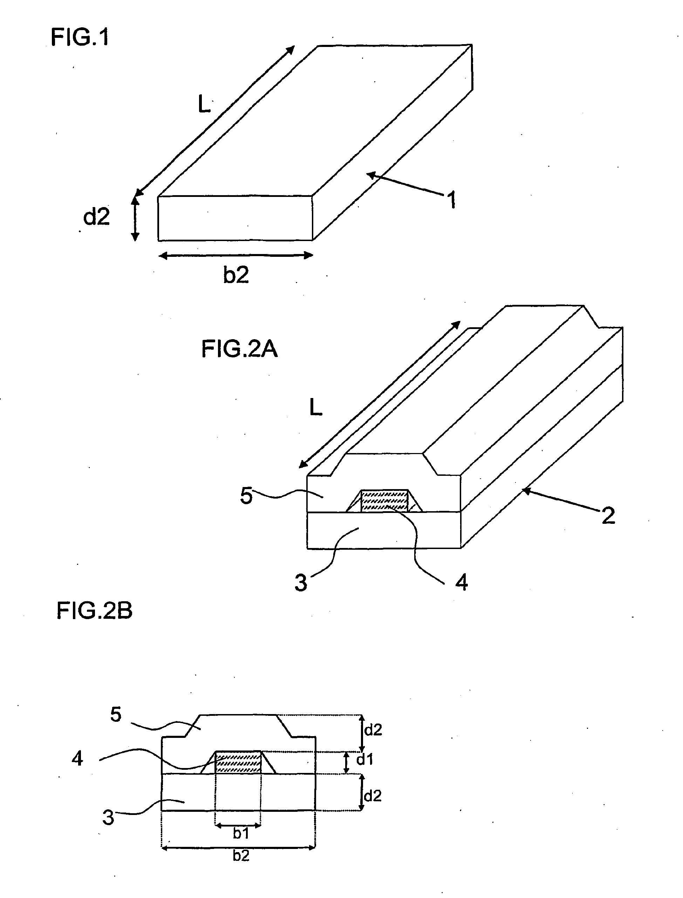

Différentes formes de réalisation du capteur peuvent être obtenues à partir de ce procédé de fabrication. La figure 1 représente une première forme de réalisation de l'invention, dans lequel un capteur magnétique 1 a sensiblement la forme d'un ruban. Ce capteur a une structure extrêmement simple qui est facile à reproduire industriellement à grande échelle.

Préférentiellement, la longueur du capteur sous la forme de ruban est environ égale à 10 fois la largeur du ruban, qui avoisine elle le centimètre. Enfin, l'épaisseur de ce ruban est en général inférieure à 50$\mu$m. En effet, un capteur ayant de telles dimensions possèdent des performances de sensibilité et de gain (amplitude de la variation d'impédance) améliorées.

Cependant, afin d'améliorer encore la sensibilité ainsi que le variation relative de l'impédance en fonction du champ magnétique, on peut préférer un capteur magnétique 2 avec une structure sandwich, illustrée par les figures 2A et 2B. Ce capteur magnétique 2 comprend une première couche de matériau magnétique 3, sur laquelle est disposée une couche conductrice 4, en général un métal. Une deuxième couche de matériau magnétique 5 est formée sur la couche conductrice 4. Cette couche 5 englobe la couche conductrice 4.

Cette structure amplifie encore la variation relative de l'impédance. De même, cette variation dépend de la conductivité et en fonction du métal employé, l'effet peut encore être accentué comme le montre le tableau suivant :

**Tableau 2 : Effet de la structure sandwich (recuit à 660˚C sous faible contrainte mécanique de traction 1-2 MPa)**

| Type de conducteur | $\left(\dfrac{\Delta Z}{Z_{sat}}\right)_{Max}$ (%) | Fréquence |
|:---:|:---:|:---:|
| Ruban simple | 60 | 1 MHz |
| Laiton | 448 | 100 kHz |
| Al | 616 | 100 kHz |
| Cu | 768 | 50 kHz |

Comme le montre le tableau précédent, la fréquence pour laquelle la variation maximale est obtenue diminue à mesure que le métal est meilleur conducteur. En conséquence, les fréquences utilisées notamment avec une couche conductrice de cuivre sont relativement faibles, ce qui permet une électronique de détection simple.

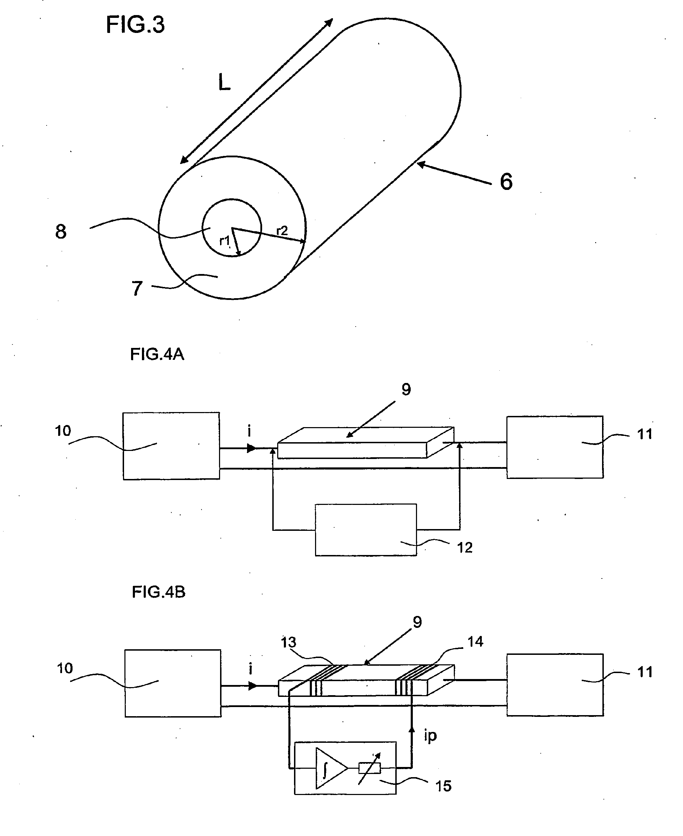

En effet, pour être utilisé, et comme le montre la figure 4A, le capteur 9 est soumis à un courant alternatif i, généré par un générateur 10. Afin de mesurer l'impédance du capteur 9, un ampèremètre 11 et une détection synchrone 12 sont utilisés. Plus la fréquence d'utilisation du capteur est faible, plus simple en est l'électronique, notamment le générateur 10. Il est en effet plus simple de mettre en oeuvre le capteur si l'électronique de détection utilise des basses fréquences.

On peut aussi utiliser, comme illustré à la figure 4B, un bobinage de détection 13 constitué de N spires permettant d'augmenter la sensibilité du capteur jusqu'à une valeur autour de 10%/A/m en polarisant le capteur 9 grâce à un autre bobinage 14 de N' spires alimenté par un courant de polarisation ip issu d'un montage 15 constitué d'un intégrateur et d'une résistance variable.

On voit d'après le tableau 2 que l'utilisation d'un conducteur diminue fortement la fréquence pour laquelle la variation est maximale.

Par ailleurs, les dimensions de chacune des couches peuvent influencer les performances du capteur.

Conformément à la figure 2B représentant une coupe d'un capteur magnétique selon cette invention, on définit :

d1 : l'épaisseur du conducteur
d2 : l'épaisseur d'une couche de matériau magnétique
b1 : la largeur du conducteur
b2 : la largeur du matériau magnétique
1 : longueur du ruban ou conducteur

Le tableau 3 présente l'influence du rapport de l'épaisseur de la couche conductrice sur l'épaisseur de la couche de matériau magnétique. En effet, en fonction de ce rapport, la variation de l'impédance est plus ou moins importante. Ce rapport est préférentiellement compris entre 0.5 et 5, car c'est pour ces valeurs que la variation de l'impédance est la plus grande. Comme le montre le tableau suivant, de préférence, ce rapport est sensiblement égal à un.

**Tableau 3 : Effet de l'épaisseur du cuivre (structure sandwich après recuit à 660˚C sous contrainte mécanique de traction 1-2 MPa) pour 1/b1=33.33 et 1/b2=10**

| d1/d2 | $\left(\dfrac{\Delta Z}{Z_{sat}}\right)_{Max}$ (%) | fréquence |
|---|---|---|
| 0.5 | 645 | 100 kHz |
| 1 | 893 | 50 kHz |
| 2 | 768 | 50 kHz |
| 3 | 660 | 50 kHz |
| 5 | 673 | 20 kHz |

De plus, l'épaisseur des couches de matériau magnétique est généralement comprise entre 1 et 50$\mu$m. Par ailleurs, l'épaisseur de la couche conductrice est en général comprise entre 10$\mu$m et 100%$\mu$m.

Ensuite, on peut faire varier le rapport des largeurs des couches. Ainsi, on préfère notamment que le rapport de la largeur b1 de la couche conductrice sur la largeur b2 de la couche de matériau magnétique soit environ égal à 0.5, c'est-à-dire que la largeur de la couche de matériau magnétique est environ égal au double de la largeur de la couche conductrice. C'est notamment ce que montre le tableau 4 :

**Tableau 4 : Effet de la largeur du cuivre (structure sandwich après recuit à 660˚C sous faible contrainte mécanique de traction 1-2 MPa) pour d1/d2=2 et 1/b2=10**

| b1/b2 | $\left(\dfrac{\Delta Z}{Z_{sat}}\right)_{Max}$ (%) | fréquence |
|---|---|---|
| 0.1 | 415 | 100 kHz |
| 0.2 | 685 | 50 kHz |
| 0.3 | 768 | 50 kHz |
| 0.5 | 982 | 20 kHz |
| 0.7 | 515 | 20 kHz |

Enfin, la longueur du capteur est de préférence égale à 10 fois la largeur de ce capteur, comme le montre le tableau 5. Ces résultats sont transposables au cas du premier mode de réalisation sous la forme du ruban, où un maximum d'amplitude de variation est détecté pour une longueur de l'ordre de 10 fois la largeur.

**Tableau 5 : Effet de la longueur du capteur (structure sandwich après recuit à 660˚C sous faible contrainte mécanique de traction 1-2 MPa) pour d1/d2=2 et b1/b2=0.5**

| 1/b2 | $\left(\dfrac{\Delta Z}{Z_{sat}}\right)_{Max}$ . (%) | Fréquence |
|---|---|---|
| 2 | 550 | 20 kHz |
| 5 | 356 | 50 kHz |
| 10 | 982 | 20 kHz |
| 15 | 593 | 50 kHz |
| 20 | 517 | 50 kHz |

Selon une variante de réalisation représentée à la figure 3, le capteur 6 est de forme sensiblement cylindrique. Une couche de matériau magnétique 7 entoure un fil conducteur 8, par exemple en cuivre ou en aluminium. Par analogie aux considérations précédentes sur l'épaisseur des différentes couches dans le cas de la structure des figures 2A et 2B, on peut jouer sur les rayons respectifs des matériaux. En conséquence, on préférera un rapport des rayons environ égal à 1.

Par ailleurs, du fait de la structure nanocristalline, un capteur obtenu par un procédé conforme à l'invention possède une stabilité thermique exceptionnelle, qui peut fonctionner dans des conditions extrêmes de températures. Ceci est notamment essentiel dans le cadre d'applications spatiales.


**Revendications**

1. Procédé de fabrication d'un capteur à magnéto-impédance nanocristallin comprenant un élément en matériau magnétique de la famille FINEMET (Fe, Si, B, Cu, Nb), comprenant une étape de recuit de l'élément en matériau magnétique effectuée à une température comprise entre 600˚C et 700˚C pendant 5 à 20 secondes, l'élément de matériau magnétique étant soumis à une perturbation extérieure de faible intensité afin de provoquer la formation de domaines magnétiques transverses, ledit matériau magnétique ayant, après recuit, une perméabilité magnétique relative supérieure à 10 000, et suivant lequel on forme le capteur magnétique par l'interposition d'une couche conductrice (4) entre une première couche de matériau magnétique (3) et une seconde couche de matériau magnétique (5), le rapport de l'épaisseur de la couche conductrice sur l'épaisseur de l'une des couches de matériau magnétique est compris entre 0,5 et 5.

2. Procédé selon la revendication 1, suivant lequel la perturbation comprend une contrainte mécanique en élongation d'une intensité comprise entre 1 et 5 MPa.

3. Procédé selon la revendication 1 ou la revendication 2, suivant lequel la perturbation comprend la soumission à un champ magnétique transverse.

4. Procédé selon l'une quelconque des revendications précédentes, suivant lequel on réalise le capteur magnétique sous la forme d'un ruban (1) de matériau magnétique d'une longueur sensiblement égale à 10 fois la largeur et d'épaisseur inférieure à 50μm.

5. Procédé selon la revendication 4, suivant lequel la longueur du capteur magnétique est comprise entre 1 millimètre et 1 centimètre.

6. Procédé selon la revendication 1, suivant lequel la couche conductrice est réalisée à partir de l'un des métaux suivants : or, cuivre, aluminium, laiton.

7. Procédé selon la revendication 1 ou la revendication 6, suivant lequel on interpose une couche isolante d'oxyde entre la couche conductrice et les couches de matériaux magnétiques.

**8.** Procédé selon l'une quelconque des revendications précédentes, suivant lequel l'épaisseur des couches de matériau magnétique est comprise entre 1μm et 50μm.

**9.** Procédé selon l'une quelconque des revendications précédentes, suivant lequel l'épaisseur de la couche conductrice est comprise entre 10μm et 100μm.

**10.** Procédé selon l'une quelconque des revendications précédentes, suivant lequel le rapport de la largeur de la couche conductrice sur la largeur de l'une des couches en matériau magnétique est compris entre 0,1 et

**Claims**

**1.** Method for producing a nanocrystalline magnetoimpedance sensor comprising an element of magnetic material from the series FINEMET (Fe, Si, B, Cu, Nb), which comprises a step of annealing the element of magnetic material carried out at a temperature between 600˚C and 700˚C for from 5 to 20 seconds, the element of magnetic material being subjected to an external disturbance of low intensity in order to bring about the formation of transverse magnetic fields, the magnetic material having, after annealing, a relative magnetic permeability greater than 10000, and wherein the magnetic sensor is formed by interposition of a conductive layer (4) between a first layer (3) of magnetic material and a second layer (5) of magnetic material, the relationship of the thickness of the conductive layer to the thickness of one of the layers of magnetic material being between 0.5 and 5.

**2.** Method according to claim 1, wherein the disturbance comprises a mechanical stress in terms of elongation with an intensity between 1 and 5 MPa.

**3.** Method according to claim 1 or claim 2, wherein the disturbance comprises being subjected to a transverse magnetic field.

**4.** Method according to any one of the preceding claims, wherein the magnetic sensor is constructed in the form of a strip (1) of magnetic material having a length which is substantially equal to 10 times the width and having a thickness which is less than 50 μm.

**5.** Method according to claim 4, wherein the length of the magnetic sensor is between one millimetre and one centimetre.

**6.** Method according to claim 1, wherein the conductive layer is produced from one of the following metals: gold, copper, aluminium, brass.

**7.** Method according to claim 1 or claim 6, wherein an insulating oxide layer is interposed between the conductive layer and the layers of magnetic materials.

**8.** Method according to any one of the preceding claims, wherein the thickness of the layers of magnetic material is between 1 μm and 50 μm.

**9.** Method according to any one of the preceding claims, wherein the thickness of the conductive layer is between 10 μm and 100 μm.

**10.** Method according to any one of the preceding claims, wherein the relationship of the width of the conductive layer to the width of one of the layers of magnetic material is between 0.1 and 1.

**Patentansprüche**

**1.** Verfahren zur Herstellung eines nanokristallinen Magnetoimpedanz-Sensors mit einem Element aus magnetischem Material aus der Familie FINEMET (Fe, Si, B, Cu, Nb), mit einem Schritt des Glühens des Elements aus magnetischem Material, durchgeführt bei einer Temperatur zwischen 600˚C und 700˚C für 5 bis 20 Sekunden, wobei das Element aus magnetischem Material einer externen Störung mit schwacher Intensität ausgesetzt ist, um die Bildung von transversen magnetischen Domänen zu provozieren, wobei das magnetische Material nach dem Glühen eine relative magnetische Permeabilität größer 10000 aufweist, und wobei man nach diesem den magnetischen Sensor durch Einsetzen einer leitenden Schicht (4) zwischen einer ersten Schicht aus magnetischem Material (3) und einer zweiten Schicht aus magnetischem Material (5) bildet, wobei das Verhältnis der Dicke der leitenden Schicht zu der Dicke einer der Schichten aus magnetischem Material zwischen 0,5 und 5 liegt.

2. Verfahren nach Anspruch 1, gemäß dem die Störung eine mechanische Dehnungsbelastung einer Intensität zwischen 1 und 5 MPa umfasst.

3. Verfahren nach Anspruch 1 oder 2, gemäß dem die Störung das Unterwerfen unter ein transversales Magnetfeld umfasst.

4. Verfahren nach einem der vorangehenden Ansprüche, gemäß dem der magnetischen Sensor in Form eines Bandes (1) aus magnetischem Material in einer Länge realisiert wird, die im Wesentlichen das 10-fache der Breite beträgt, und in einer Dicke, die kleiner als 50$\mu$m ist.

5. Verfahren nach Anspruch 4, gemäß dem die Länge des magnetischen Sensors zwischen einem Millimeter und einem Zentimeter liegt.

6. Verfahren nach Anspruch 1, gemäß dem die leitende Schicht ausgehend von einem der nachfolgenden Metalle realisiert ist: Gold, Kupfer, Aluminium, Messing.

7. Verfahren nach Anspruch 1 oder Anspruch 6, gemäß dem eine isolierende Oxidschicht zwischen die leitende Schicht und die Schichten aus magnetischen Materialien eingesetzt wird.

8. Verfahren nach einem der vorangehenden Ansprüche, gemäß dem die Dicke der Schichten aus magnetischem Material zwischen 1$\mu$m und 50$\mu$m liegt.

9. Verfahren nach einem der vorangehenden Ansprüche, gemäß dem die Dicke der leitenden Schicht zwischen 10$\mu$m und 100$\mu$m liegt.

10. Verfahren nach einem der vorangehenden Ansprüche, gemäß dem das Verhältnis der Breite der leitenden Schicht zu der Breite einer der Schichten aus magnetischem Material zwischen 0,1 und 1 liegt.

FIG.1

L

d2

b2

1

FIG.2A

L

5

3    4

2

FIG.2B

5

4

3

d2

d1

d2

b1

b2

FIG.3

L

6

8

r1  r2

7

FIG.4A

10

i

9

11

12

FIG.4B

10

i

13    9    14

11

ip

15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5852531 A
- EP 0271657 A2
- EP 0299498 A1
- US 5252148 A
- US 6053989 A

**Littérature non-brevet citée dans la description**

- **F. Alves.** Flash stess annealings in nanocrystalline alloys for new inductive components. *Journal of Magnetism and Magnetic Materials,* 2001, vol. 226-230, 1490-1492
- **F. Alves et al.** Stress-induced anisotropy in Finemet- and Nanoperm-type nanocrystalline alloy using flash annealing. *Journal of Magnetism and Magnetic Materials,* 2000, vol. 215-216, 387-390
- **F. Alves et al.** Influence of rapid stress annealing on magnetic and structural properties of nanocrystalline Fe74.5Cu1Nb3Si15.5B6 alloy. *Journal of Magnetism and Magnetic Materials,* 2005, vol. 294, e141-e144
- **Y. Yoshizawa et al.** New Fe-based soft magnetic alloys composed of ultrafine grain structure. *Journal of Applied Physics,* 1988, vol. 64, 6044-6046